Europäisches Patentamt

European Patent Office

Office européen des brevets

(11) Numéro de publication: **0 390 642**
**A1**

## (12) DEMANDE DE BREVET EUROPEEN

(21) Numéro de dépôt: **90400759.8**

(51) Int. Cl.5: **G01R 1/073**

(22) Date de dépôt: **20.03.90**

(30) Priorité: **24.03.89 FR 8903925**

(43) Date de publication de la demande:
**03.10.90 Bulletin 90/40**

(84) Etats contractants désignés:
**DE GB IT**

(71) Demandeur: **THOMSON COMPOSANTS MICROONDES**
**51, Esplanade du Général de Gaulle**
**F-92800 Puteaux(FR)**

(72) Inventeur: **Gloanec, Maurice**
**Thomson-CSF, SCPI - Cédex 67**

**F-92045 Paris La Défense(FR)**
Inventeur: **Jarry, Jacques**
**Thomson-CSF, SCPI - Cédex 67**
**F-92045 Paris La Défense(FR)**
Inventeur: **Belloche, Thierry**
**Thomson-CSF, SCPI - Cédex 67**
**F-92045 Paris La Défense(FR)**
Inventeur: **Leroux, Joelle**
**Thomson-CSF, SCPI - Cédex 67**
**F-92045 Paris La Défense(FR)**

(74) Mandataire: **Taboureau, James et al**
**THOMSON-CSF SCPI**
**F-92045 Paris La Défense Cédex 67(FR)**

(54) **Carte à pointes pour le test des composants semiconducteurs hyperfréquences.**

(57) L'invention concerne une carte à pointe de tests pour les composants semiconducteurs hyperfréquences.

Le coeur d'une carte support (12), de dimensions normalisées pour les appareils de tests sous pointes existant, est remplacé par un circuit (15) centré sur la fenêtre de mesure qui supporte les pointes (24). Sur ce circuit (15) la propagation des signaux se fait au moyen de lignes microbandes (18) qui réunissent les pointes (24) à des connecteurs radiaux (21) hyperfréquences. Le circuit hyperfréquence est formé sur une plaque de cuivre (17) sur laquelle est laminée une feuille diélectrique (16), et des secteurs de masse (19) séparent les lignes microbandes (18). Des composants passifs (30) ou actifs (31,32) sont reportés au plus près des pointes, sur le circuit hyperfréquence (15) et sur la carte support (12).

Application aux tests de composants hyperfréquences, sous pointes, jusque 5 à 6 GHz dans une gamme de température jusqu'à 125° C.

FIG_4

## CARTE A POINTES POUR LE TEST DES COMPOSANTS SEMICONDUCTEURS HYPERFREQUENCES.

La présente invention concerne un dispositif de test de circuits intégrés, connu sous l'appellation "carte à pointes". En association avec un appareil de positionnement mécanique des pointes sur une pastille de circuits intégrés, et avec un analyseur, une carte à pointes permet de trier les circuits, avant découpe de la plaque de matériau semiconducteur. La carte à pointes selon l'invention est dédiée aux hyperfréquences et permet d'opérer des mesures jusque environ 5 à 6 GHz en fréquence, en raison de ses liaisons de hautes performances qui réunissent, sur la carte, les plots métalliques sur la puce de circuit intégré, et les connecteurs des câbles coaxiaux qui partent vers l'analyseur.

La majorité des tests des composants semiconducteurs, circuits intégrés et composants discrets, nécessaires pour la vérification des spécifications, sont actuellement opérés de façon collective et automatique, directement sur plaques, à la sortie des chaînes de fabrication.

Ce procédé utilise universellement un ensemble de tests composé d'un testeur assurant la génération et la mesure des composants électriques nécessaires aux mesures, associé à une machine de test automatique , munie d'une carte à pointes adaptée à la topologie du circuit sous tests. L'ensemble est géré automatiquement par un processeur qui assure le déroulement des séquences de test, la gestion de la machine de test, la mémorisation des résultats de tests et l'identification des puces défectueuses.

Cette configuration des tests sur plaques, motivée par les gains en coût et en temps de cycle, a évolué avec les générations de testeurs, adaptés à la complexité des dispositifs sous tests, mais se heurte à une limitation en fréquence de fonctionnement.

Les cartes à pointes traditionnelles, utilisées pour la mesure des circuits Silicium courants, offrent de bonnes performances jusqu'à quelques dizaines de MHz. Sur ce type de cartes réalisées en verre-époxy, aucune précaution n'est prise au niveau de la connectique qui est assurée par simple photogravure des conducteurs. Le nombre d'accès, et par conséquent le nombre de pointes, peut dépasser la centaine.

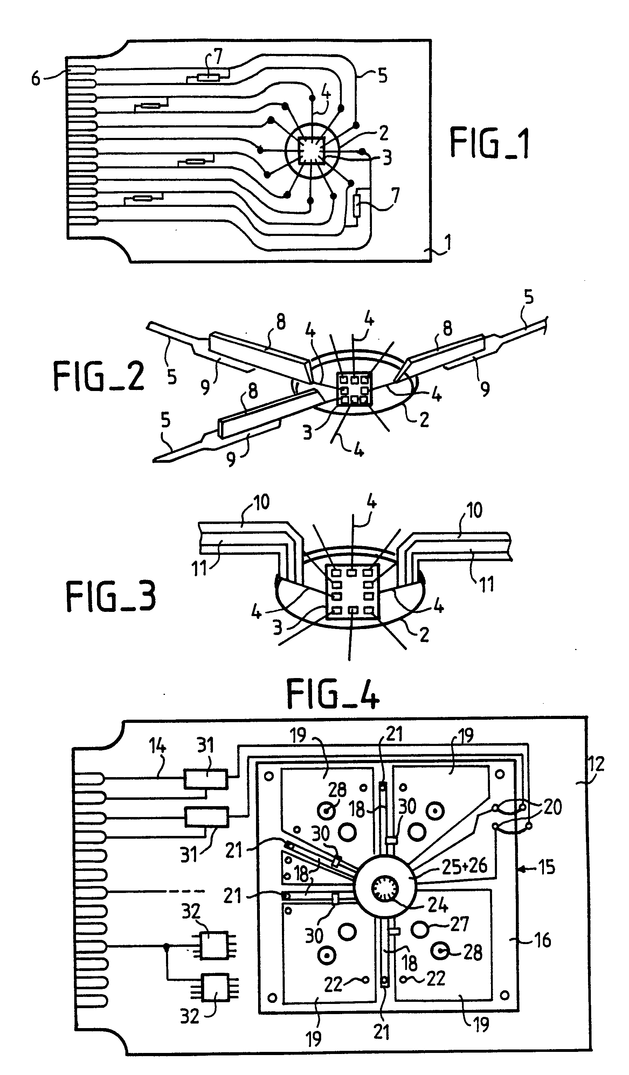

La figure 1 rappelle la structure d'une telle carte à pointes selon l'art connu. Une plaque 1 de verre-époxy, d'un format normalisé, comporte dans une région approximativement centrale une fenêtre 2 d'environ 2 à 3 cm de diamètre. Sur la machine de test, le circuit intégré 3 est déplacé pour être centré dans la fenêtre 2. Dans le cas le plus fréquent où une carte à pointes est dédiée à un type de circuit, pour la fabrication, une pluralité de pointes 4 sont fixées sur la carte de telle façon que, pour chacune, l'extrêmité de la pointe 4 vienne en contact sur une plage métallisée de la puce du circuit. A partir des pointes 4, des pistes métallisées ordinaires 5 courent sur le substrat de verre-époxy 1 jusqu'à des plages métallisées 6, en bout de substrat, qui s'enfichent dans un connecteur plat, non représenté. Des capacités 7 de liaison ou de découplage peuvent être ajoutés en divers points de la carte à pointe : à ces fréquences relativement basses de quelques mégahertz, les capacités sont relativement grosses, et leur position n'est pas cruciale.

La figure 1, comme les autres figures, est simplifiée de façon à la rendre plus lisible : peu de pointes, et de simples traits pour les métallisations basses fréquences.

La figure 2 représente une vue dans l'espace de la région de la fenêtre 2, agrandie pour en montrer le détail. Trois pointes seulement sont représentées, les autres ne sont qu'esquissées. La carte 1 en verre-époxy, non représentée, est située par la fenêtre 2.

Les pointes 4 sont en fait fixées sur une lamelle métallique 8, dans son prolongement, et la lamelle 8 est à son tour brasée sur une plage 9 qui termine chaque piste métallisée 5. Le procédé est simple, industriel, mais il est évident que si l'on considère deux lamelles 8 voisines et proches l'une de l'autre, dans le cas où il y a plusieurs dizaines de pointes, ces lamelles présentent un effet capacitif qui ne fait qu'empirer avec l'argumentation de la fréquence.

Il n'est donc pas possible avec ce type de carte à pointes de tester des circuits intégrés ou des composants discrets réalisés soit sur silicium, soit sur GaAs ou matériaux III- V et fonctionnant à au moins 1 GHz.

Le développement des familles de composants ultra-rapides pose, d'une façon générale, le problème de mise en oeuvre de ce type de caractérisation. S'il est possible d'envisager la mise en oeuvre d'équipements de mesures adaptés à la performance des dispositifs sous test par association de matériels programmables, le problème des liaisons de hautes performances vers la puce reste posé.

Il existe une solution, commercialisée, qui donne de bons résultats en fréquence, mais qui est extrêmement coûteuse et fragile - donc inexploitable en fabrication -, et d'une mise en oeuvre délicate. Elle est sommairement représentée en figure 3.

Dans le même contexte que celui de la figure précédente, cette solution consiste à réunir au moins une pointe 4 à une lamelle de céramique 10, qui porte une ligne microbande 11. La lamelle de céramique 10 est en forme de crosse, et la pointe 4 est soudée sur la ligne microbande 11 à l'extrêmité en biais de la lamelle de céramique. Il y a donc un problème d'adaptation au niveau de la jonction avec la pointe 4. Il y a ensuite un second problème d'adaptation au niveau de la seconde extrémité de la ligne microbande 11 : en effet, les lamelles 10 et les lignes 11 sont perpendiculaires par rapport au plan de la fenêtre de test 2, et il n'est pas aisé d'y fixer un connecteur ou un câble semi rigide. La juxtaposition de plusieurs lamelles de ce type constitue une carte à pointes très fragile, et délicate à régler.

C'est pour satisfaire le besoin manifeste dans les nouvelles technologies III-V fonctionnant au-delà de 1 GHz qu'un nouveau type de cartes à pointes hautes fréquences, a été développé.

Un premier objet de l'invention est de proposer une carte à pointes, interchangeable avec les cartes à pointes normalisées, mais permettant une fréquence de fonctionnement d'au moins 5 GHz, pour des circuits ayant une pluralité d'accès hautes fréquences - 6 à 8 - et testés jusqu'à 125 ° C.

Un second objet de l'invention est que les cartes à pointes soient adaptées aux normes des machines de test, avec une technique de montage des sondes de test identique à celle des cartes de test standard, de façon à en faire un produit simple, industriel et peu coûteux.

L'invention consiste donc en une carte à pointes de format standard, dont la région qui entoure la fenêtre de mesure est constituée par une plaque rapportée. Cette plaque est en métal-cuivre doré pour constituer à la fois un radiateur et un plan de masse. Sur la plaque est une couche de matériau isolant, qui supporte elle-même des lignes microbandes, qui convergent vers un anneau métallique qui entoure la fenêtre. Des pointes, courtes, sont brasées sur les lignes microbandes et s'appuient sur l'anneau ; elles sont isolées entre elles par une couche d'époxy. Entre les lignes microbandes, des secteurs métallisés sont réunis au plan de masse de la plaque métallique. Toutes les entrées-sorties se font au plus près de la fenêtre par des connecteurs coaxiaux.

De façon plus précise, l'invention concerne une carte à pointes pour le test des composants semi-conducteurs hyperfréquences, comportant une carte support d'adaptation aux appareils de tests sous pointes, et une fenêtre munie de pointes de tests, cette carte à pointes étant caractérisée en ce que la partie centrale de la carte support, entourant la fenêtre, évidée, supporte un circuit hyperfréquence plan sur lequel les liaisons entre les pointes de tests et des connecteurs coaxiaux hyperfréquence se font au moyen de lignes microbandes, séparées entre elles par des secteurs de plans de masse, de façon à limiter la désadaptation du circuit à la seule longueur des pointes.

L'invention sera mieux comprise par la description plus détaillée qui suit d'un exemple de réalisation, en liaison avec les figures jointes en annexes qui représentent :

- figure 1 : vue en plan d'une carte à pointes selon l'art connue, précédemment analysée,
- figures 2 et 3 : vues de détails des pointes selon l'art connu exposées plus haut,
- figure 4 : vue en plan d'une carte à pointes selon l'invention,

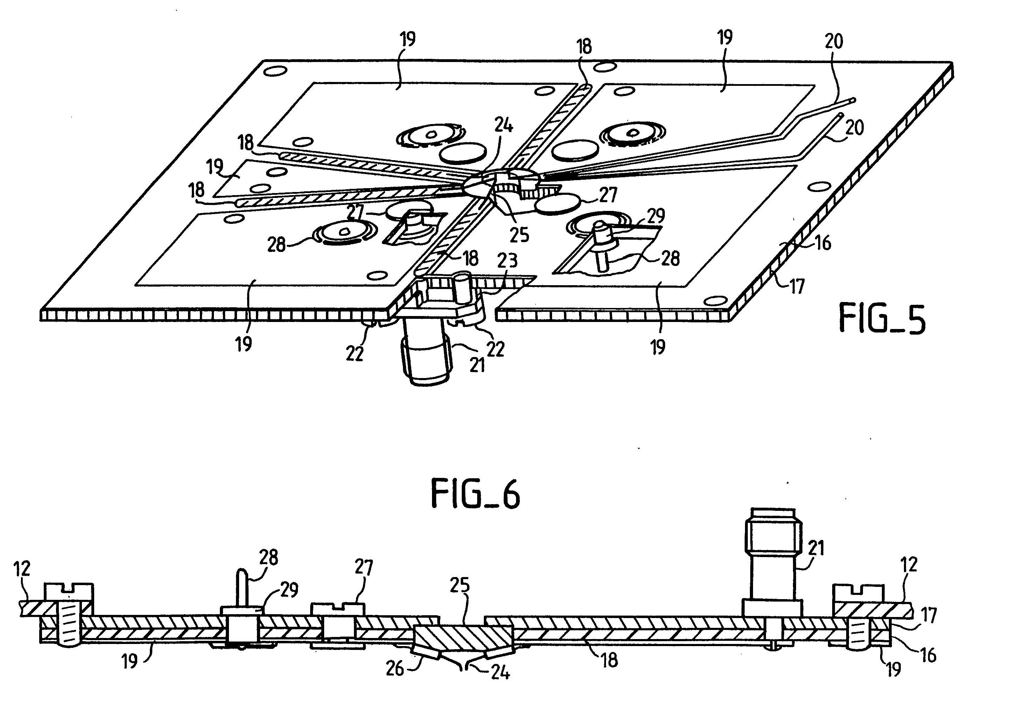

- figure 5 : vue de trois-quart du coeur d'une carte à pointes selon l'invention,
- figure 6 : coupe du coeur d'une carte selon l'invention.

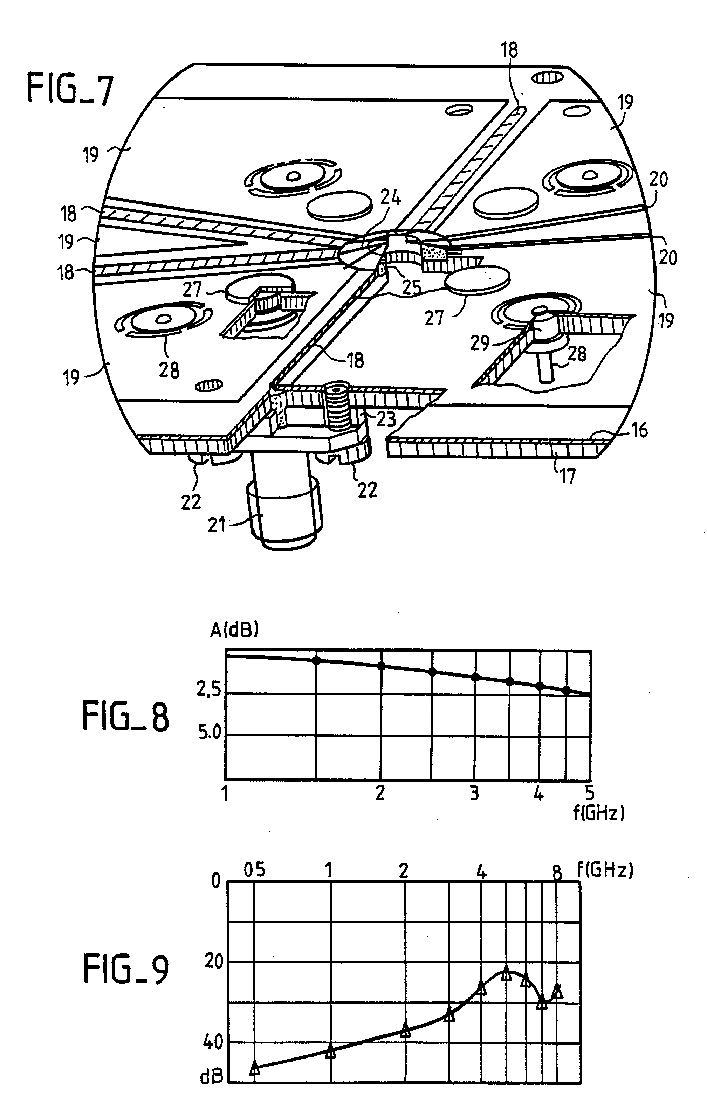

- figure 7 : agrandissement de la partie centrale du coeur d'une carte selon l'invention,
- figures 8 et 9 courbes de caractéristiques en fréquence d'une carte selon l'invention.

La figure 4 représente une carte à pointes selon l'invention, vue par dessous, c'est à dire du côté qui fait face à la puce de semiconducteur sous test. Comme pour les figures suivantes, celle-ci est très simplifiée, avec un petit nombre de pistes conductrices, de façon à la rendre plus lisible.

Cette carte comprend une carte support 12 réalisée en stratifié verre-époxy haute température donnant à l'ensemble une présentation identique à celle d'une carte normalisée, ce qui facilite son emploi sur les machines de test existantes. Cette carte 12 comprend un connecteur enfichable 13 et une pluralité de pistes métallisées 14 : ce connecteur et ces pistes basse fréquence servent essentiellement au contrôle de positionnement des pointes, en courant continu.

La partie centrale 15, ou coeur, de la carte à pointes selon l'invention constitue la partie originale, qui est plus détaillée sur les figures 5 et 7. Rapporté par des moyens mécaniques sur la carte support 12, le coeur 15 est un circuit gravé sur un substrat isolant 16 supporté par une plaque de cuivre doré 17. Le substrat 16 est par exemple un laminé de céramique et de polytétrafluoro éthylène, à hautes performances électriques, présentant une faible dispersion de sa constante diélectrique, voisine de 10,5 et une bonne stabilité thermique pour les conducteurs utilisant le mode de propagation par lignes microbandes.

La semelle de cuivre 17 a une triple fonction :
- elle supporte et rigidifie la pellicule 16 de céramique PTFE
- elle constitue un plan de masse pour les lignes microbandes.
- elle sert de radiateur de dissipation thermique pour les mesures faites en température, à + 125 °

C par exemple.

La pellicule laminée 16 de céramique - PTFE supporte une métallisation en cuivre doré dans laquelle sont gravées :
- une pluralité de lignes microrubans 18, toutes convergeantes vers la fenêtre de mesure au centre de la plaque,
- une pluralité de secteurs 19 de plans de masse séparant les lignes microrubans 18,
- des lignes de transmission 20, par exemple pour les alimentations en courant continu du dispositif semiconducteur sous test.

Les départs depuis les lignes microbandes 18 vers les câbles coaxiaux de raccordement à l'appareil de mesure se font au moyen de connecteurs coaxiaux hyperfréquences 21, fixés sur la semelle 17 de cuivre au moyen de vis 22, et d'une plaquette 23 servent de cale d'épaisseur.

Pour des raisons de simplification, et afin de ne pas multiplier les types de connecteurs, les alimentations en courant continu peuvent passer également par des connecteurs coaxiaux 21 identiques à ceux qui transportent des signaux hyperfréquences.

Tous ces connecteurs coaxiaux sont, en fonction de leur nombre, fixés au plus près de la fenêtre centrale, mais à une distance suffisante pour connecter ou déconnecter aisément selon les besoins. La chaîne lignes microbandes 18/connecteurs coaxiaux 21/câbles coaxiaux fait qu'il n'y a pas de désadaptation.

Au centre de la carte sont disposées les sondes de test. Ce sont de courtes aiguilles ou pointes 24, en palladium ou en cuivre-béryllium pour assurer une pression de contact de l'ordre de 2 grammes sur la pastille semiconductrice; elles sont cambrées à leur extrêmité de façon à être mieux positionnées sur la pastille. La longueur de ces pointes 24 est réduite au minimum, environ 2 à 3 mm, de façon à minimiser la désadaptation d'impédance des sondes hyperfréquences.

Ces pointes 24 sont disposées radialement, couchées par rapport au plan du coeur 15 de la carte. Celle de leurs extrêmités qui n'appuie pas sur la pastille sous test est soudée, au moyen d'un alliage étain-plomb où plomb-indium :
- soit sur une ligne microbande 18 hyperfréquence,
- soit sur une piste conductrice 20 pour celles qui amènent une polarisation continue ou véhiculent un signal basse fréquence,
- soit sur un secteur 19 de plan de masse : les sondes de masse, reliées à des secteurs écrans, isolent les sondes hyperfréquences entre elles.

Dans les cas des lignes 18 et des pistes 19, celles-ci sont dans l'axe des aiguilles 24.

Parmi les pointes 24, il en est deux qui fonctionnent en palpeur de positionnement de la pastille semiconductrice par rapport à la plaque qui supporte l'ensemble des aiguilles. La première de ces deux pointes est normalement cambrée pour toucher la plaque de semi-conducteurs, la seconde pointe établit un contact électrique et mécanique avec la première pointe. Lorsque la première pointe touche la pastille, le contact s'ouvre ou se ferme, selon le montage choisi, et la machine de test arrête le déplacement du support de test sur lequel est placée la plaque de semiconducteurs.

Toutes les pointes 24, sont couchées sur un anneau 25 en aluminium anodisé pour le rendre isolant. Cet anneau a une surface d'appui des pointes qui est légèrement inclinée -ce qui lui donne donc une coupe en tronc de cône- de façon à diriger les pointes vers la plaque de semiconducteurs sous test.

Les pointes 24 sont immobilisées contre l'anneau 25, et en position par rapport à la pastille sous test, par une couche 26 de résine époxy ou de toute autre colle haute température. Cette couche 26 est supprimée sur les figures 5 et 7, de façon à laisser voir les pointes 24, mais est visible en coupe sur la figure 6.

La partie du coeur de la carte à pointes selon l'invention comporte encore des pions de court-circuit 27, qui mettent les secteurs métallisés 19 à la masse de la plaque de cuivre 17 qui sert de support. Ces pions sont constitués par une vis à tête plate : si on la dévisse, le court-circuit entre le secteur 19 concerné et la plaque 17 est interrompu : cela permet de contrôler la planéité des sondes de masse au moyen d'un connecteur 28, implanté dans chaque secteur 19 auquel est reliée une sonde de masse 24. Ce connecteur 28 est serti à force dans la plaque de cuivre 17, à travers une gaine d'isolement 29.

Enfin, de façon à parfaire la qualité des liaisons électriques entre les pointes 24 et l'environnement extérieur, des composants 30 montables en surface sont soudés au plus près des pointes, entre les pistes 20, lignes microbandes 18 et les plans de masse 19. Ce sont selon les cas des capacités et des selfs de découplage pour les alimentations, des capacités de liaisons, des résistances d'adaptation et de polarisation. Ces composants ne sont pas représentés sur les figures 5 et 7 de façon à les rendre plus claires.

De même, la partie de la carte support 12 comprise entre le connecteur 13 et le circuit hautes fréquences 15 peut recevoir un certain nombre de composants tels que des relais 31 qui permettent de tester les fonctions du circuit semiconducteur 3 les unes après les autres, par exemple en interrompant une alimentation. Les relais 31, visibles sur la figure 4, sont en fait situés de l'autre côté de la plaque 12 par rapport au plan de la figure, car le côté qui fait face au dispositif semiconducteur doit être très plat : tout relief doit être inférieur à celui des aiguilles 24 (fig. 6).

En outre, afin de minimiser les altérations sur les mesures dynamiques, l'environnement hautes fréquences de la carte à pointes selon l'invention permet l'adjonction de circuits semiconducteurs 32 au plus près des composants à mesurer sous pointes : ce sont par exemple des circuits GaAs diviseurs de fréquence ou les circuits existant dans une configuration réelle d'utilisation de circuits en cascade.

Cette disposition permet de s'affranchir au mieux des problèmes de retard et de décalages de phases dus aux longueurs de connexions, qui sont réduites dans le cas de l'invention si un circuit 32 en GaAs est placé proche d'une ligne microbande 18. Les circuits hyperfréquences 32 peuvent être rapportés sur la carte support 12 soit sous forme de boitier, soit en circuit hybride.

Ainsi, la partie de circuit de test comprise entre les pointes 24 et les connecteurs hyperfréquences 21, constitué de linges microbandes 18 et comportant des composants d'adaptation 30 au plus près de la fenêtre de test, n'est que très peu désadaptée : seules les pointes 24, sur une longueur de l'ordre de 2 mm, présentent une désadaptation.

La qualité des liaisons effectuées est traduite par le relevé de la figure 8 qui présente l'affaiblissement en transmission dans la bande de fréquence 1 à 5 GHz (valeur pour une sonde, pertes des câbles de transmission déduites). L'affaiblissement reste inférieur à 3 dB jusqu' à 5 GHz.

La mesure du découplage interligne conduit, comme le montre la figure 9, à une diaphonie supérieure à 20 dB jusque 8 GHz.

D'autre part, ce nouveau type de cartes permet un fonctionnement hautes fréquences dans une gamme de température jusqu'à 125 ° C. Cette disponibilité permet d'opérer toutes les caractérisations directement sur plaques, selon les meilleurs critères de coût et d'efficacité. En raison de la simplicité de la carte à pointes selon l'invention, il est facile de réaliser des cartes spécialisées pour chaque circuit intégré, dans un centre de fabrication industrielle.

**Revendications**

1 - Carte à pointes pour le test des composants semiconducteurs hyperfréquences, comportant une carte support (12) d'adaptation aux appareils de tests sous pointes, et une fenêtre munie de pointes de tests (24), cette carte à pointes étant caractérisée en ce que la partie centrale de la carte support (12), entourant la fenêtre, évidée, supporte un circuit hyperfréquence plan (15) sur lequel les liaisons entre les pointes de tests (24) et des connecteurs coaxiaux (21) hyperfréquence se font au moyen de lignes microbandes (18), séparées entre elles par des secteurs de plans de masse (19), de façon à limiter la désadaptation du circuit à la seul longueur des pointes (24).

2 - Carte à pointes selon la revendication 1, caractérisée en ce que le circuit hyperfréquence (15) est réalisé sur une couche de matériau diélectrique (16), de type céramique - polytétrafluoro éthylène, à forte constante diélectrique, ladite couche étant laminée sur une plaque métallique (17), de type cuivre doré, qui sert de radiateur et de plan de masse pour les lignes microbandes (18) et les secteurs de plans de masse (19), gravés dans une couche métallique déposée sur la couche diélectrique (16).

3 - Carte à pointes selon la revendication 2, caractérisée en ce que les pointes de tests (24) sont appuyées sur un anneau (25) d'aluminium inséré, incrusté dans le circuit hyperfréquence (15) autour de la fenêtre de test, lesdites pointes (24) étant immobilisées dans une couche isolante (26) de type polymère, et soudées sur une première extrêmité d'une ligne microbande (18) ou sur un secteur de plan de masse (19), une pointe de test étant située entre deux pointes à la masse.

4 - Carte à pointes selon la revendication 2, caractérisée en ce que les secondes extrêmités des lignes microbandes (18) sont reliées à des connecteurs coaxiaux hyperfréquences (21), vissés dans la plaque métallique (17) du circuit hyperfréquence (15) au plus près de la fenêtre de test.

5 - Carte à pointes selon la revendication 2, caractérisée en ce que des pions (27) métalliques, démontables, établissent des court-circuits entre les secteurs (19) de plan de masse et la plaque métallique (17), plan de masse du circuit à lignes microbandes.

6 - Carte à pointes selon la revendication 2, caractérisée en ce que des plots métalliques (28) sont insérés à force dans le circuit hyperfréquence (15), chaque plot étant isolé dans une gaine (29), mais relié à un secteur de plan de masse (19).

7 - Carte à pointes selon la revendication 1, caractérisée en ce que la carte support (12), en stratifié de type verre-époxy résistant à haute température, comporte un connecteur (13) enfichable, et supporte au moins un composant basse fréquence, tel qu'un relais (31) d'alimentation.

8 - Carte à pointes selon la revendication 1, caractérisée en ce que la carte support (12) reçoit au moins un composant haute fréquence (32), de type circuit intégré cascadable avec le composant semiconducteur sous test.

9 - Carte à pointes selon la revendication 1, caractérisée en ce que des composants passifs (30) de liaison ou de découplage, tels que capacités, selfs, résistances, sont fixés sur le circuit hyperfréquence (15), de côté des lignes microbandes (18), au plus près de la fenêtre qui supporte les pointes (24).

FIG_1

FIG_2

FIG_3

FIG_4

EP 0 390 642 A1

FIG_5

FIG_6

FIG_7

FIG_8

FIG_9

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | US-A-4 686 463 (LOGAN)<br>* Colonne 1, lignes 5-10; colonne 2, lignes 58-61; colonne 3, lignes 19-35; colonne 5, lignes 23-50; colonne 6, lignes 45-57; figures 1,6 *<br>--- | 1,2,4,9 | G 01 R 1/073 |
| Y | EP-A-0 226 995 (TEKTRONIX)<br>* Colonne 3, lignes 3-20,54-57; colonne 4, lignes 7-17; figures 1,5 * | 1,2,4,9 | |
| A | --- | 5,6 | |
| A | US-A-4 780 670 (CHERRY)<br>* Colonne 2, lignes 2-13; colonne 3, lignes 21-26; colonne 3, ligne 61 - colonne 4, ligne 13; figures 1,2 *<br>----- | 1-3,7-9 | |

| | | |
|---|---|---|
| | | **DOMAINES TECHNIQUES RECHERCHES (Int. Cl.5)**<br><br>G 01 R |

Le présent rapport a été établi pour toutes les revendications

| Lieu de la recherche | Date d'achèvement de la recherche | Examinateur |
|---|---|---|
| LA HAYE | 18-07-1990 | SINAPIUS G.H. |